# EUROPEAN PATENT APPLICATION

(11) **EP 2 194 540 A1**
(43) Date of publication of application: **09.06.2010**
(21) Application number: 08460046.9
(22) Date of filing: 08.12.2008
(51) Int. Cl.: H01B 17/00, H03H 7/01, H03H 7/38

(54) **High voltage bushing**

(71) Applicant: ABB Research Ltd., 8050 Zürich (CH)
(72) Inventor: Piasecki, Wojciech, 30-611 Krakow (PL); Florkowski, Marek, 31-216 Krakow (PL)
(74) Representative: Chochorowska-Winiarska, Krystyna

(57) **Abstract**

The subject of the invention is a high voltage bushing finding application in conducting electric current from the outer environment to the inside of a piece of electrical power equipment through the walls of such equipment. The high voltage bushing (1) is fixed to the wall of the piece of electrical power equipment (2) and it contains an insulating body (3) in which there is a serial impedance element (4) connected with an outer phase conductor (5) and with a bushing terminal (6). The characteristic feature of the inventive bushing is that the serial impedance element (4) is placed in the insulating material of the insulating body (3) and has the form of an RL circuit comprising an induction coil (9) and a resistor (10) connected with it in parallel, and the bushing terminal (6) is connected to one terminal of at least one capacitive capacitor (7) located in the insulating material of the insulating body (3), whose other terminal is earthed on the housing of the piece of electric power equipment (2).

## Description

The subject of the invention is a high voltage bushing finding application in conducting electric current from the outer environment to the inside of a piece of electrical power equipment such as a distribution transformer, a power transformer or a power reactor, through such equipment walls.

Known electrical power equipment functioning in power networks, for example power transformers, is furnished with bushings which are installed in the transformer cover and which are suitable for embeding in them high-potential electrical conductors in order to provide the electrical connection to the transformer. Traditional bushings consist of an insulating body made of ceramic or composite material, fitted with a flange for fixing the bushing in the transformer wall or cover. Typically, a bushing have an axial port for placing the conductor in it. Inside the insulating body, around the conductor port, there are electric field-shaping screens in the form of electrically conducting material and insulating layers situated concentrically around the conductor. Bushings with electric field-shaping screens are called capacitive bushings.

There are also known bushings containing fuses located in the ports in the bushing body. An example of a high voltage bushing with fuses is shown in the patent description US 3962667**.**

Electrical power equipment working in power systems is exposed to the effects of unfavourable high frequency phenomena arising in consequence of switching processes or lightning surges. To prevent such phenomena various types of protecting devices are used. Such devices are connected between the terminal of the protected equipment and earth. The function of the protective devices is, first, to reduce the rate of rise in voltage occurring on the terminals of electric or electric power equipment, and second, to reduce the value of overvoltage expressed by voltage surge amplitude. These two adverse phenomena result in accelerated degradation of the insulating system of electric power equipment. Protecting devices use protecting elements in the form of surge capacitors or RC two-terminal networks. The use of the above protecting elements consists mainly in ensuring impedance matching between the piece of electric power equipment and the power line, and in a certain limitation of the rate of rise in voltage. Both systems require the use of large capacitance values, which results in large sizes of protecting devices.
A device for reducing the rate of rise in voltage, intended for protecting electrical equipment connected with an electric conductor situated in a bushing, is known from patent application WO2006/115458**.** This device has smaller dimensions compared with known protecting devices, preferably it is situated inside the bushing body and it has the form of a suitably earthed capacitor of a cylindrical design, inside which an electrical conductor of high potential is placed. This device can also be located outside the bushing body, between the bushing and the protected piece of electrical equipment, and it also can be situated inside the protected piece of equipment.
A device for attenuating high-frequency current or voltage components, protecting electrical equipment against the effects of voltage surges in power systems and stations is known from patent application EP1895550**.** This device contains a serial impedance element in the form of at least one magnetic core reactor comprising anti-parallel-connected windings, and the reactor can be located inside a high-voltage bushing.
The essential quality of the inventive bushing fixed to the wall of electrical power equipment housing and comprising an insulating body with a serial impedance element placed in it, which is connected with an outer phase conductor and with a bushing terminal electrically connected with the piece of electrical power equipment is that the serial impedance element is placed in the insulating material of the insulating body and has the form of an RL circuit comprising an induction coil and a resistor connected to it in parallel, and the bushing terminal is connected to one terminal of at least one capacitor located in the insulating material of the insulating body. The other terminal of the capacitive capacitor is earthed on the housing of the piece of electrical power equipment.

Preferably, the bushing contains at least one overvoltage limiter whose one terminal is connected to the bushing terminal and the other terminal is earthed on the housing of the piece of electrical power equipment.

Preferably, the overvoltage limiter is located in the insulating body.

Preferably, the serial impedance element contains a capacitor which is connected in parallel with the induction coil.

In the second embodiment of the invention, the essential quality of the inventive bushing fixed to the wall of electrical power equipment housing and comprising an insulating body with a serial impedance element placed in it, which is connected with an outer phase conductor and with the bushing terminal electrically connected with the piece of electrical power equipment, is that the serial impedance element is placed in the insulating material of the insulating body and has the form of an RL circuit comprising an induction coil and an additional induction coil magnetically coupled with that former coil, the additional coil being connected with a resistor, and the bushing terminal is connected to one terminal of at least one capacitor located in the insulating material of the insulating body. The other terminal of the capacitive capacitor is earthed on the housing of the piece of electrical power equipment.

Preferably, in the second embodiment of the invention, the bushing contains at least one overvoltage limiter whose one terminal is connected to the bushing terminal and the other terminal is earthed on the housing of the piece of electrical power equipment.

Preferably, in the second embodiment of the invention, the overvoltage limiter is placed in the insulating body.

Preferably, in the second embodiment of the invention, the serial impedance element contains a capacitor which is connected in parallel with the induction coil.

Alternatively, in the second embodiment of the invention, the serial impedance element contains a capacitor which is connected in parallel with the resistor.

Preferably, in both embodiments of the invention, the resistor is placed inside an induction coil along its longitudinal axis.

Preferably, in both embodiments of the invention, the bushing is connected to the housing of a power transformer.

Preferably, in both embodiments of the invention, the bushing is connected to the housing of a power reactor.

Preferably, in both embodiments of the invention, the bushing is connected to the housing of an electrical motor.

Preferably, in both embodiments of the invention, the bushing is connected to the housing of a high voltage generator.

The use of both a serial impedance element and a capacitor inside the bushing makes it possible to effectively reduce both the rate of rise in voltage dU/dt and the overvoltage value by means of one element, without the need to attach additional external elements. Such solution makes it possible to reduce the dimensions of the device for attenuating high-frequency components of current and voltage by assembling important protection elements in one housing which can substitute a traditional bushing.

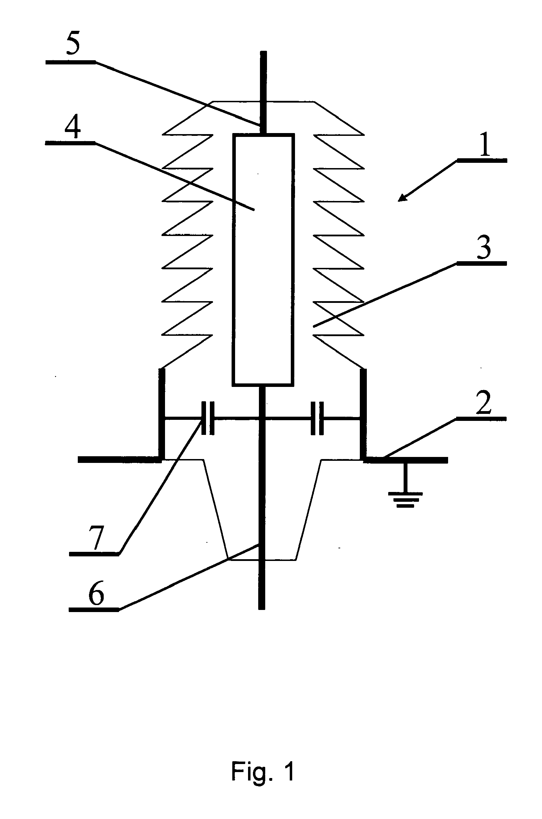

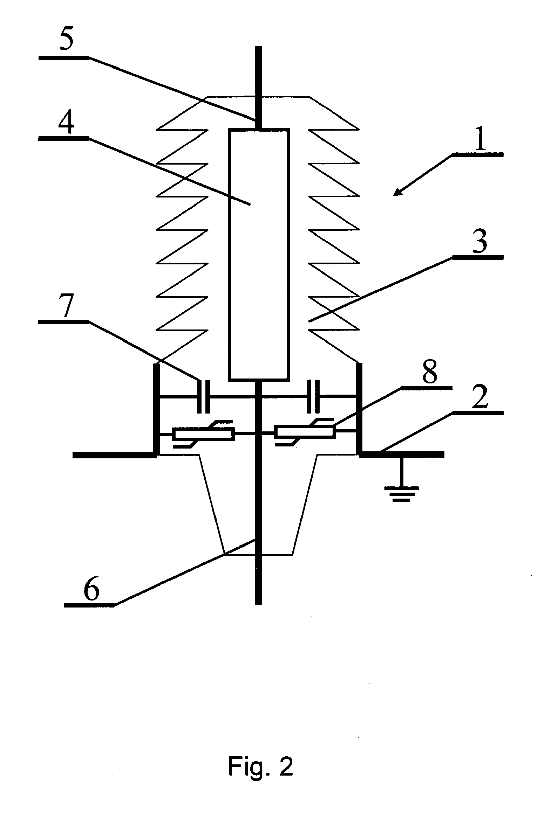

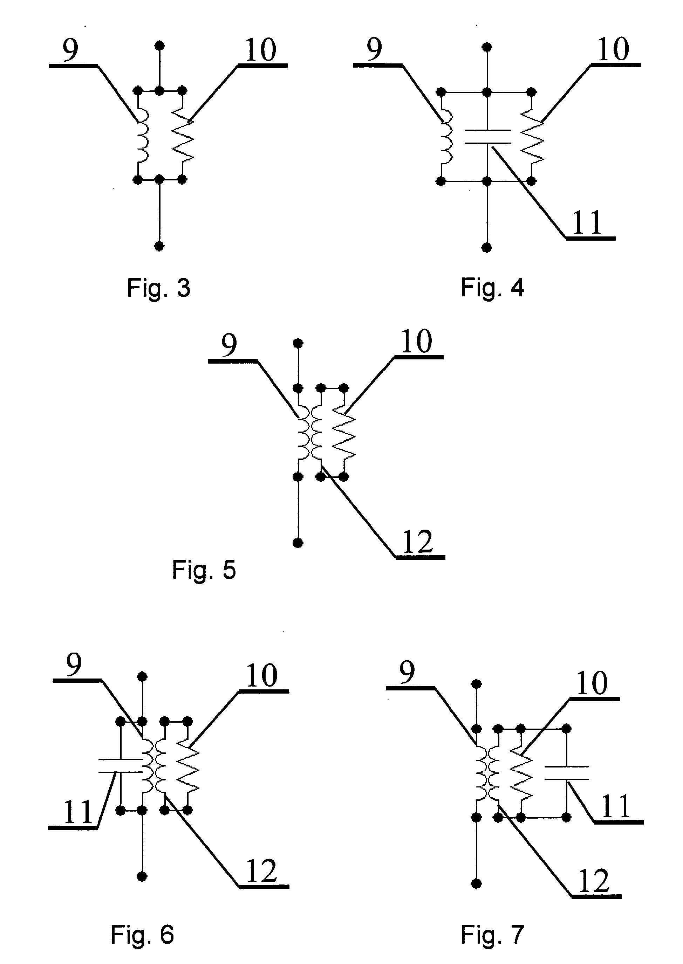

The inventive device is presented as an embodiment in the drawing where fig. 1 schematically shows the first and the second embodiments of the bushing as a longitudinal section, fig. 2 - the bushing from fig. 1 with additional overvoltage limiters, fig. 3 - the serial impedance element in the first version of the first variety of the invention embodiment, fig. 4 - the serial impedance element with a capacitor in the second version of the first variety of the invention embodiment, fig. 5 - the serial impedance element with an additional induction coil in the first version of the second variety of the invention embodiment, fig. 6 the serial impedance element in the second version of the second variety of the invention embodiment, with an additional induction coil and a capacitor connected in parallel to the induction coil, fig. 7 - the serial impedance element in the third version of the second variety of the invention embodiment, with an additional induction coil and a capacitor connected in parallel to a resistor.
A bushing 1 is fixed in the wall of the earthed housing of a piece of electrical power equipment 2, which in the embodiment is a power transformer. The bushing 1 has a cast body 3 in which there is a serial impedance element 4 connected on one side with an outer phase conductor 5 and on the other side with an internal bushing terminal 6. The terminal 6 is connected with the secondary winding of the transformer, not shown in the picture. In the cast body 3 there is located at least one capacitive capacitor 7 whose one terminal is connected to the bushing terminal 6, and the other is earthed on the transformer housing 2.

In the first variety of the invention embodiment, the impedance element 4 is placed in the insulating material of the insulating body 3 and it has the form of an RL circuit consisting of an induction coil 9 and a resistor 10 connected with it in parallel. The bushing terminal 6 is connected to one terminal of at least one capacitor 7 which is placed in the insulating material of the insulating body 3. The other terminal of the capacitive capacitor 7 is earthed on the housing of the transformer 2.

In the second variety of the invention embodiment, the impedance element 4 is placed in the insulating material of the insulating body 3 and it has the form of an RL circuit consisting of an induction coil 9 and an additional induction coil 12 magnetically coupled with it, connected in parallel with a resistor 10. The bushing terminal 6 is connected with one terminal of at least one capacitor 7 located in the insulating material of the insulating body 3. The other terminal of the capacitive capacitor is earthed on the housing of the transformer 2.
In both varieties of the invention embodiment, in the cast body 3 there is placed additionally at least one overvoltage limiter 8 functioning as a device protecting against voltage surges, whose one terminal is connected to the evacuating line 6, and the other is earthed on the transformer housing 2. The overvoltage limiter 8 can be placed in a separate protective housing, not shown in the drawing. In the embodiment, the overvoltage limiter is situated in the housing of the cast body 3. The overvoltage limiter can be situated outside the housing of the body 3, both in the housing 2 or outside this housing, which is not shown in the drawing.
In the first version of the first variety of the invention embodiment (fig. 1 or fig. 2, fig. 3) the serial impedance element 4 is an RL circuit and it contains an induction coil 9 and a resistor 10 connected in parallel with each other.
In the second version of the first variety of the invention embodiment (fig. 1 or fig. 2, fig. 4) the serial impedance element contains a capacitor 11 which is connected in parallel with an induction coil 9 and a resistor 10.
In the first version of the second variety of the invention embodiment (fig. 1 or 2, fig. 5) the serial impedance element is an RL circuit and it contains an additional induction coil 12, which is magnetically coupled with the induction coil 9 and is connected in parallel with the resistor 10.
In the second version of the second variety of the invention embodiment (fig. 1 or 2, fig. 6) the serial impedance element contains a capacitor 11 which is connected in parallel with an induction coil 9 and contains an additional induction coil 12 which is magnetically coupled with the induction coil 9 and is connected in parallel with the resistor 10.
In the third version of the second variety of the invention embodiment (fig. 1 or 2, fig. 7) the serial impedance element contains an induction coil 12 magnetically coupled with the induction coil 9 and contains a capacitor 11 which is connected in parallel with the resistor 10.
In the presented invention embodiment example the piece of electrical power equipment containing the inventive bushing is a power transformer. However, this bushing can be an element of other electrical power equipment such as power reactors, high voltage motors or generators, functioning in electric power grids. In all embodiments of the invention, in the serial impedance element, the resistor 10 can be located inside the induction coil 9, which is not shown in the drawing.

## Claims

1. A high voltage bushing fixed to the wall of the housing of a piece of electrical power equipment (2), comprising an insulating body (3) in which there is placed a serial impedance element (4) connected with an outer phase conductor (5) and with a bushing terminal (6) electrically connected with the piece of electrical power equipment (2), **characterised in that** the serial impedance element (4) is located in the insulating material of the insulating body (3) and has the form of an RL circuit comprising an induction coil (9) and a resistor (10) connected with it in parallel, and the bushing terminal (6) is connected with one terminal of at least one capacitive capacitor (7) located in the insulating material of the insulating body (3), whose second terminal is earthed on the housing of the piece of electric power equipment (2).

2. A bushing according to claim 1, **characterised in that** it contains at least one overvoltage limiter (8) whose one terminal is connected to the bushing terminal (6) and the other terminal is earthed on the housing of the piece electrical power equipment (2).

3. A bushing according to claim 2, **characterised in that** the overvoltage limiter (8) is located in the insulating body (3).

4. A bushing according to claim 1 or 2 or 3, **characterised in that** the serial impedance element (4) contains a capacitor (11) which is connected in parallel with the induction coil (9).

5. A high voltage bushing fixed to the wall of the housing of a piece of electrical power equipment (2), comprising an insulating body (3) in which there is placed a serial impedance element (4) connected with an outer phase conductor (5) and with a bushing terminal (6) electrically connected with the piece of electrical power equipment (2), **characterised in that** the serial impedance element (4) is placed in the insulating material of the insulating body (3) and has the form of an RL circuit comprising an induction coil (9) and an additional induction coil (12) magnetically coupled with it, connected in parallel with a resistor (10), and the bushing terminal (6) is connected to one terminal of at least one capacitor (7) placed in the insulating material of the insulating body (3), whose second terminal is earthed on the housing of the piece of electric power equipment (2).

6. A bushing according to claim 5 **characterised in that** it contains at least one overvoltage limiter (8) whose one terminal is connected to the bushing terminal (6) and the other terminal is earthed on the housing of the piece of electric power equipment (2).

7. A bushing according to claim 6, **characterised in that** the overvoltage limiter (8) is placed in the insulating body (3).

8. A bushing according to claim 5 or 6 or 7, **characterised in that** the serial impedance element (4) contains a capacitor (11) which is connected in parallel with the induction coil (9).

9. A bushing according to claim 5 or 6 or 7, **characterised in that** the serial impedance element (4) contains a capacitor (11) which is connected in parallel with the resistor (10).

10. A bushing according to any of the above claims, **characterised in that** the resistor (10) is placed inside the induction coil (9) along its longitudinal axis.

11. A bushing according to any of the above claims, **characterised in that** it is connected to the housing of a power transformer.

12. A bushing according to any of the above claims, **characterised in that** it is connected to the housing of a power reactor.

13. A bushing according to any of the above claims, **characterised in that** it is connected to the housing of an electric motor.

14. A bushing according to any of the above claims, **characterised in that** it is connected to the housing of a high voltage generator.
